# EUROPEAN PATENT SPECIFICATION

(11) **EP 1 639 641 B1**
(45) Date of publication and mention of the grant of the patent: **16.02.2011**
(21) Application number: 04736788.3
(22) Date of filing: 14.06.2004
(51) Int. Cl.: H01L 23/495, H01L 21/48

(54) **METHOD OF MANUFACTURING A SEMICONDUCTOR DEVICE WITH A LEADFRAME AND APPARATUS THEREFOR**
VERFAHREN ZUR HERSTELLUNG EINER HALBLEITERVORRICHTUNG MIT EINEM LEITERRAHMEN UND VORRICHTUNG HIERZU
PROCEDE POUR FABRIQUER UN DISPOSITIF SEMI-CONDUCTEUR AVEC UN CADRE DE MONTAGE ET APPAREIL POUR SA MISE EN OEUVRE

(30) Priority: 18.06.2003 EP 03101790
(43) Date of publication of application: 29.03.2006
(73) Proprietor: NXP B.V., 5656 AG Eindhoven (NL)
(72) Inventor: HESEN, Paulus, M., C., NL-5656 AA Eindhoven (NL); VAN DE WATER, Peter, W., M., NL-5656 AA Eindhoven (NL); SCHRIKS, Cornelis, G., NL-5656 AA Eindhoven (NL)
(74) Representative: Schouten, Marcus Maria
(86) International application number: PCT/IB2004/050896
(87) International publication number: WO 2004/112132

(56) References cited:
- EP-A- 0 794 571
- US-A- 3 736 367
- US-A- 4 252 864
- US-A- 5 225 897
- US-A- 6 005 287
- US-A1- 2001 054 640

## Description

The invention relates to a method of manufacturing a semiconductor device comprising the steps of providing a semiconductor element provided with a first and a second electric connection region, which connection regions are situated on opposite sides of the semiconductor element; providing a lead frame comprising a frame with a first and a second connection conductor, which connection conductors are each connected to the frame and provided with an exposed end portion; attaching the semiconductor element to the end portion of the first connection conductor, an electroconductive connection between the first connection region and the end portion by using a connection means; and making an electroconductive connection between the second connection region and the end portion of the second connection conductor using a connection means. Such a method enables, in particular discrete semiconductor devices with, for example, a diode or a transistor as the semiconductor element, to be readily manufactured.

A lead frame and a method of the type mentioned in the opening paragraph are known from Japanese patent specification JP-04-338640, published under number JP-A-06-188346 on 8 July 1994. Said document describes that, in a plane frame of a lead frame, two strip-shaped connection conductors are defined on two opposite sides of the lead frame. One connection conductor is provided, near the exposed end portion thereof, of a semiconductor element, the other connection conductor is attached at one end or in the center, to the lead frame by means of two narrow (metal) strips situated on either side of the connection conductor. By rotating this connection conductor through 180 degrees, where the axis of rotation extends along said narrow strips, the connection conductor is moved out of the plane of the frame and rotated to a position above the position of the semiconductor element. Next, this conductor is attached to the (upper side of) the semiconductor element.

A drawback of the known lead frame and of the known method is that said lead frame is less suitable for the manufacture of devices comprising, in particular, semiconductor elements such as transistors. In that case, two strip-shaped connection conductors must be attached to one side of the element because a transistor requires three connection conductors. This cannot be easily achieved with the method described above, in particular if the semiconductor element has comparatively small dimensions. If so, it is no longer readily possible to manufacture the two connection conductors to be rotated as well as their connection to the lead frame by means of the narrow strips such that they are sufficiently large and strong.

JP04-093055 (as referred to in US 6,005,287) discloses a leadframe and method as described in the preamble of claim 1.

US 4 252 864 discloses a continuous strip of stamped and formed lead frames for a semi-conductor chip comprises spaced apart parallel carrier strips with the lead frames connected to one of the carrier strips at regularly spaced intervals. Each lead frame comprises a chip supporting portion which is centrally located between the carrier strips, and second arm which extends from the chip support portion towards one of the carrier strips and first and third arms on each side of the chip support portion which extend towards the other carrier strip. Terminal tabs are provided on each of the arms, the first and third tabs on the first and third arms extending parallel to each other towards the other carrier strip and the tab on the second arm extending parallel to the other tabs and towards the one carrier strip. Each lead frame is secured to the one carrier strip by a connection section extending from the second tab. The chip support portion and the first and third arms are additionally supported by a removable support member extending from the other carrier strip.

EP 794 571 A1 discloses a frame consisting of two mounting strips linked together at regular intervals with transverse segments between which are provided co-planar tongues each formed as one piece with a lateral mounting strip. The tongues of each pair face one another without touching, one having a free end section forming a mounting for the semiconductor crystal. The other tongue at the height of its free end has a pre-punched metal strip connector which can be bent over so that it is in contact with the semiconductor crystal. This strip is located in the volume defined by the planes which enclose the long edges of the tongues.

It is an object of the invention to provide methods of the type mentioned in the opening paragraph, which enable semiconductor devices having small dimensions to be manufactured.

To achieve this, in accordance with the invention, a method as claimed in claim 1 and an apparatus in accordance with claim 4 is provided.

### Embodiments for bending the lead frame:

In a preferred embodiment of the method in accordance with the invention, the end portion of the second connection conductor is bent through approximately 90 degrees out of the plane of the frame, and the end of the end portion is bent, along a further bending axis extending substantially parallel to the bending axis and at a distance therefrom corresponding approximately to the thickness of the semiconductor element, through an angle of approximately 90 degrees to the position of the semiconductor element.

The part of the end portion situated between the axes is of course maintained in the position of 90 degrees with respect to the frame. In the first place, it is easier to carry out the bending process in two steps because the associated deformation and introduction of stress are smaller. Secondly, it thus becomes easier to make the two connection conductors extend, at the location of the position of the semiconductor element, in directions that are substantially parallel or that include an angle with each other which can be chosen more or less freely. Also calibrating, where necessary, thus becomes easier.

Preferably, the end portion of the second connection conductor is bent along the further bending axis or along another bending axis in such a manner that said end portion extends obliquely in at least one direction with respect to the end portion of the first connection conductor which contains the position for the semiconductor element. The semiconductor element can thus be readily clamped between the conductors, as the semiconductor element is not brought to the intended position on the first conductor until after the second connection conductor has been bent. Particularly in the case of a transistor, it is advantageous if the second and a further connection conductor, which will both be bent, extend obliquely in two directions with respect to the first connection conductor, after they have been bent.

Besides a clamping effect, this also has a directing (self-aligning) effect on the element if said element is slid between the connection conductors. By virtue thereof, industrial application, i. e. mass-production, is facilitated.

### Embodiments for placing the semiconductor element:

In a particularly favorable modification, the semiconductor element is clamped between the connection conductors.

After the element has been slid between the conductors, it is electroconductively connected thereto. For this purpose use may be made of for example solder balls or solder that are situated on the element or on a side of the conductors facing the element. Next, the element is preferably provided with a passivating synthetic resin envelope, after which the redundant parts are removed from the lead frame.

A device which is suitable for all steps of the method additionally comprises means for bending at least one of the connection conductors along a bending axis which makes an oblique angle with the longitudinal axis.

In a favorable modification, where the element is not slid over a conductor to its position, the device also comprises pressure means for pressing downward one of the conductors when a pushing force is being exerted on the semiconductor element.

In one embodiment, the semiconductor element is a semiconductor diode. The second connection conductor is u-shaped or j-shaped prior to bending, and the oblique angle is chosen to range between 70 and 80 degrees. As a result, the contacts of the connection conductors are in line with each other.

In another embodiment, the semiconductor element is a semiconductor transistor with a third connection region. For this reason, there is also a third connection conductor having a contact and an end portion facing away from said contact. This end portion is bent along a bending axis which extends at an oblique angle with respect to the longitudinal axis of the end portion, such that the end portion is situated opposite the third electric connection region, with which it is electroconductively connected, while the contact is situated in the same plane as the contact of the first connection conductor. This embodiment is not known from said prior-art document and cannot be realized at all, or only with difficulty, if use is made of the lead frame described therein.

Advantageously, the second and third connection conductor are situated on either side of the first connection conductor, and the oblique angles are angles of approximately 45 degrees. In this manner, the space obtained is optimally used, and the semiconductor device can be maximally miniaturized.

It is additionally possible that the semiconductor device accommodates more than one semiconductor element, in which case one of the connection conductors can be used as an interconnect. The first connection conductor is preferably used for this purpose.

The first connection conductor is provided with a hole at a distance from the position for the semiconductor element. Such a hole simplifies the manufacture of the device.

These and other aspects of the invention are apparent from and will be elucidated with reference to the embodiment (s) described hereinafter.

In the drawings:
Figs.1 and 2 are diagrammatic plan views of an embodiment of a semiconductor device with a diode in successive stages of the manufacture carried out by means of a method in accordance with the invention,
Figs. 3 and 4 are diagrammatic plan views of an embodiment of a semiconductor device with a transistor in successive stages of the manufacture carried out by means of a method in accordance with the invention,
Fig. 5 is a diagrammatic perspective view of an embodiment of a semiconductor device with a transistor in a stage of the manufacture carried out by means of a method not in accordance with the invention,
Fig. 6 diagrammatically shows a perspective, phantom view of a semiconductor device with a transistor in an end stage of the manufacture with the aid of a method in accordance with the invention, and
Figs. 7 through 9 are diagrammatic, perspective views of an apparatus for carrying out a method in accordance with the invention.

The Figures are not drawn to scale and some dimensions, such as dimensions in the thickness direction, are exaggerated for clarity. In the various Figures, like areas or parts are indicated by means of the same reference numerals, whenever possible.

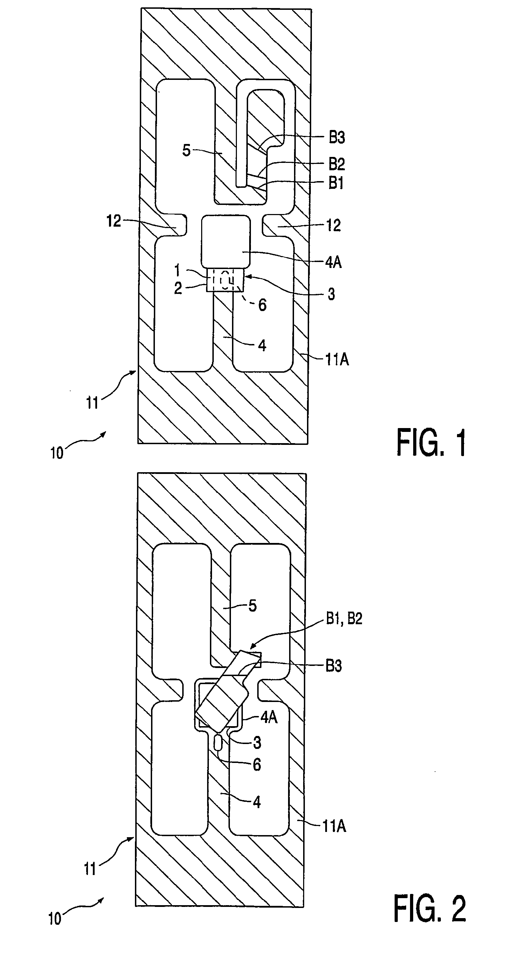

Figs.1 and 2 are diagrammatic, plan views of an embodiment of a semiconductor device with a diode in successive stages of the manufacture carried out by means of a method in accordance with the invention. A flat lead frame 11 (see Fig. 1) is used as the starting structure and comprises a frame 11 to which two strip-shaped connection conductors 4,5 are attached. The first conductor 4 has an enlarged end portion 4A which forms a suitable position for a semiconductor element 3, in this case a diode 3. Directly before the position 4A for the element 3, there is a hole 6 in the conductor 4. Via said hole 6 a diode 3, which is placed above the hole 6 on the conductor 4, for example by means of (vacuum) tweezers, can be maintained in position by means of a suction device, not shown, which is situated below the hole 6. On an opposite side of the frame 11A, a second strip-shaped connection conductor 5 is attached to said frame, a first part of said second strip-shaped connection conductor being in line with the conductor 4, and a second part, forming an end portion of the conductor 5, being formed so as to be situated along the first part and face the side of attachment thereof. The second part is widened near its end portion and is further provided with a folding line B1 and, in this case, also of two further folding lines B2, B3 which may serve as bending axes of the second part of the conductor 5. The entire second part can be rotated along the bending axis B through 180 degrees out of the plane of the frame.

In this example, however, (see Fig. 2) the second part of the second connection conductor 5 is bent upwards along the axis (and folding line) B1 through 90 degrees. Next, this part is bent again through approximately 90 degrees, in this case slightly more than 90 degrees, along the second axis (and folding line) B2, as a result of which the end portion of the second conductor is bent to a position above the position 4A of the first conductor 4. The fact that this is possible is determined, apart from the geometry and position of the second part of the second conductor 5, by the position and orientation of the bending axis B 1. These are such that after the part of the second conductor 5 which is situated above the axis B1 in Fig. 1, has been mirror-reflected with respect to the axis B1, said part becomes situated exactly in the desired position above the end portion 4A of the first conductor 4. To achieve this, it is necessary that the axis B1 makes an oblique angle with the longitudinal axis of the conductor 5. In this example, said angle is approximately 75 degrees. The distance between the axes B1, B2 is chosen to be approximately equal to the thickness of the element 3 to be placed. In this example (after it has been bent twice through, respectively, 90 and 75 degrees) the end portion of the second conductor 5 is additionally bent through a small angle of, in this case, approximately 10 degrees along the bending axis B3. Said bending axis makes an oblique angle of approximately 60 degrees with the longitudinal axis of the conductor 5. In the final state, the part of the conductor 5 that is situated above the position 4A of the first conductor 4 then makes a small angle with the conductor 4. An advantage of this modification, where the conductors 4, 5 are attached on opposite sides of the frame 11A, is that the frame 11A may be provided with, occasionally desired, bulges 12 on two sides of the position 4A for the element 3.

Next, the diode 3 is slid from the position shown in Fig. 1 to the position shown in Fig. 2 and fixed between the two conductors 4, 5. By virtue of the small angle between the two conductors 4, 5, the diode 3 can be easily slid between them and fixed in position. Subsequently, by means of heating, the diode 3 is soldered to both conductors 4, 5. The conductors 4,5 as well as the diode 3 have been made suitable for this purpose by providing solder dots or balls on a conductor 4, 5 or on the diode 3, and by the presence of a suitable metal on an opposite surface. Next, the diode 3 is provided with an envelope, not shown, for example of an epoxy material. Finally, the redundant parts of the lead frame 11 are removed, for example by cutting. The parts of the connection conductors 4, 5 projecting from the envelope then form the contacts of the device 10 which is ready for mounting on, for example, a PCB (= Printed Circuit Board).

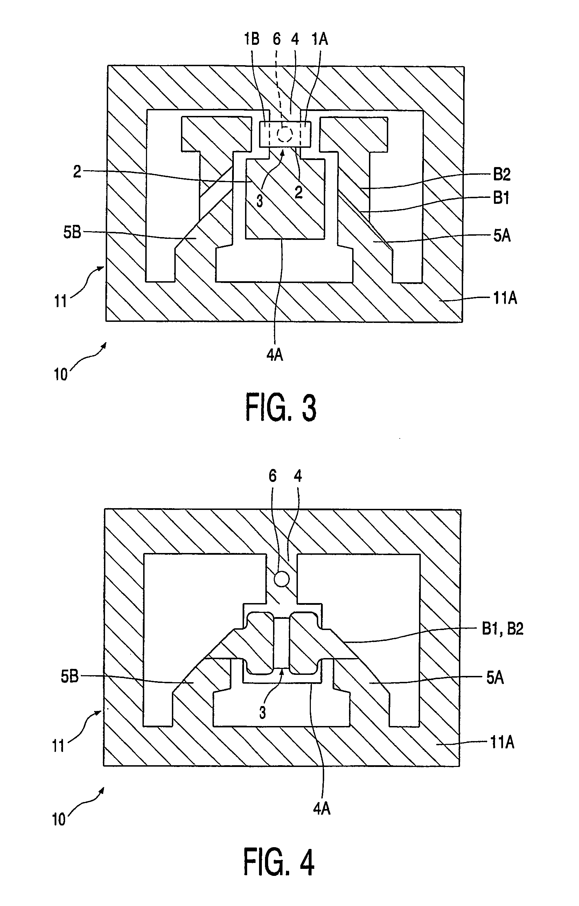

Figs. 3 and 4 are diagrammatic, plan views of an embodiment of a semiconductor device with a transistor in successive stages of the manufacture carried out by means of a method in accordance with the invention. The manufacture takes place in a way analogous to that described above with respect to an element 3 containing a diode. In this example, (see Fig. 3) the element 3 is a transistor 3. The lower side thereof is a connection region 2, in this case for the collector, and on the upper side there are two connection regions 1A, 1B for the base and the emitter of the, in this case bipolar, transistor 3. The first conductor 4 of the lead frame 11 does not differ from that described in the previous example. In view of the connection regions 1A, 1B on the upper side of the transistor 3, the frame 11A is provided, in this case, with a second and a third, parallel strip-shaped connection conductors 5A, 5B, hereinafter also referred to as the further conductors, of which the end portion is widened, and which run parallel on either side of the conductor 4, and are attached on opposite sides to the frame 11A. In this example, bending (see Fig. 4) takes place along two bending axes B1, B2 which each make an angle of 45 degrees with the longitudinal axis of the conductors 4, 5. By virtue of this and of the geometry of the further conductors 5A, 5B and of the position of the folding lines B1, B2, the widened end portions of the further conductors 5a, 5B become situated, after bending twice through approximately 90 degrees, above the position 4A of the first conductor 4, as indicated in the drawing. Subsequently, from the position shown in Fig. 3 the transistor 3 is slid over the first conductor 4 to the position shown in Fig. 4. The transistor 3 is fixed between, on the one hand, the first conductor 4 and, on the other hand, the further conductors 5A, 5B. After the transistor 3 has been soldered and enveloped, and redundant parts have been removed from the lead frame 11, the device 10 is ready for final mounting.

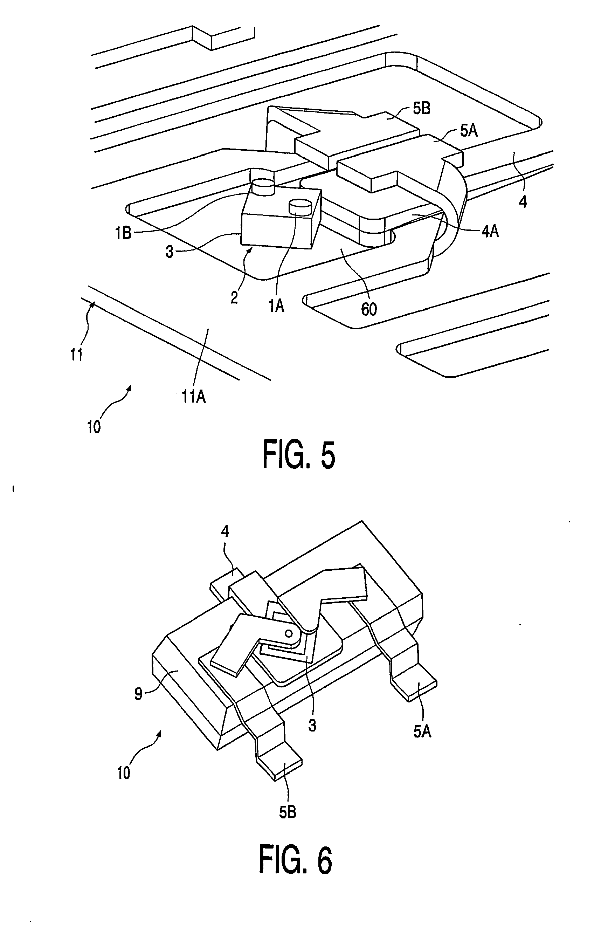

Fig. 5 is a diagrammatic, perspective view of an embodiment of a semiconductor device with a transistor in a stage of the manufacture carried out using an alternative method. The stage shown in Fig. 5 corresponds to that shown in Fig. 4, yet Fig. 5 depicts the situation prior to the state where the transistor 3 has been slid to a position between the first conductor 4 and the further conductors 5A, 5B.

The difference with the manufacture described with respect to Figure 4 relates to the position of the transistor 3 before the transistor is slid in between the conductors 4, 5: now the transistor is not situated on the first conductor 4 anterior to the end portion 4A thereof, but on an opposite side thereof within a recess of the lead frame 11. In this example, the lead frame 11 is therefore placed on a substrate 60 which, at the location of the transistor 3 as shown in Fig. 5, comprises an opening 66, not shown in the drawing, below which there is a suction device, not shown either, by means of which the transistor is fixed following its placement in the position shown in Fig. 5.

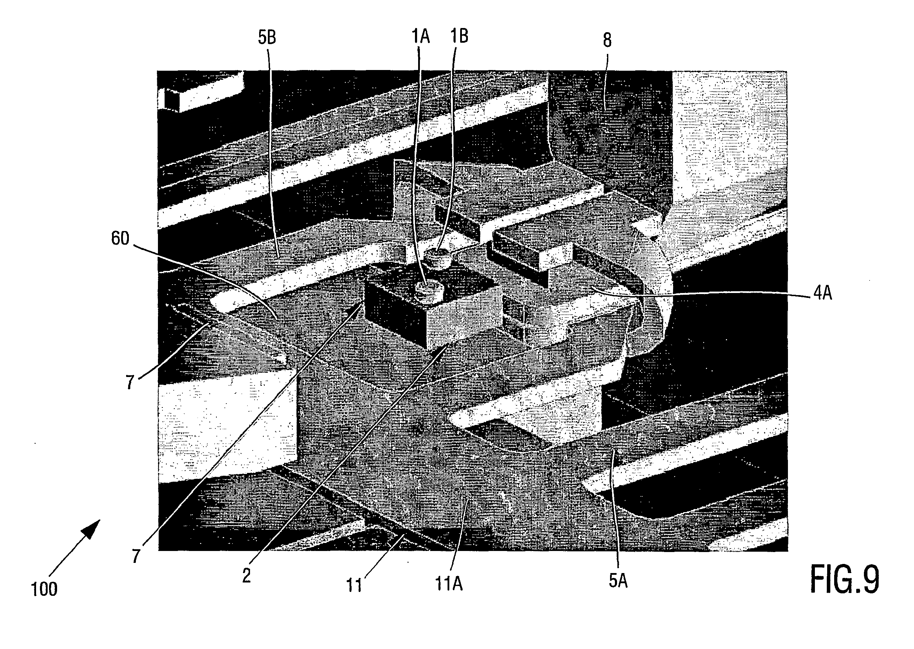

After bending of the further conductors 5A, 5B, which may take place either before or after the shown placement of the transistor 3, said transistor 3 is slid again between the conductors 4, 5. To make this possible, the substrate 60 is provided with a recess at the location of the first conductor 4, and prior to displacing the transistor 3, the first conductor 4 is pressed into the recess over a distance corresponding to the thickness of the lead frame 11 by means of a pressure member 8, as shown in Fig. 9 but not in Fig. 5. After the transistor 3 has been slid between the conductors 4, 5, the pressure member is removed again, thus causing the transistor 3 to be fixed between the conductors 4, 5. The manufacturing process is then continued and completed as described hereinabove.

Fig. 5 further clearly shows that if the end portions 5A, 5B make a small angle with both the longitudinal axis of the conductor 4 and with a direction extending perpendicularly to the longitudinal axis of conductor 4, the element 3 can be slid readily, rapidly and in a self-aligning manner, as it were, between the conductors 4, 5, resulting in said element being tight fit between said conductors. The choice of the direction of the angle with respect to the longitudinal axis of the conductor 4 is determined in this case by the direction from which the element 3 is slid between the conductors 4, 5.

Fig. 6 is a diagrammatically shows a perspective, phantom view of a semiconductor device with a transistor obtained by means of a method as described with respect to Figs. 3 and 4 or 5. The dimensions of a finished device 10 are, for example, 2 x 3 x 1 mm, which are the dimensions of the envelope 9 shown in Fig. 6. The element 3 itself then measures, for example, 0.4 x 0.4 x 0.2 mm. The thickness and the width of the conductors 4, 5 are, in this case, 0.1 mm and 0.4 mm respectively. The length of the parts of the conductors 4, 5 projecting from the envelope 9 is approximately 1 mm in this case.

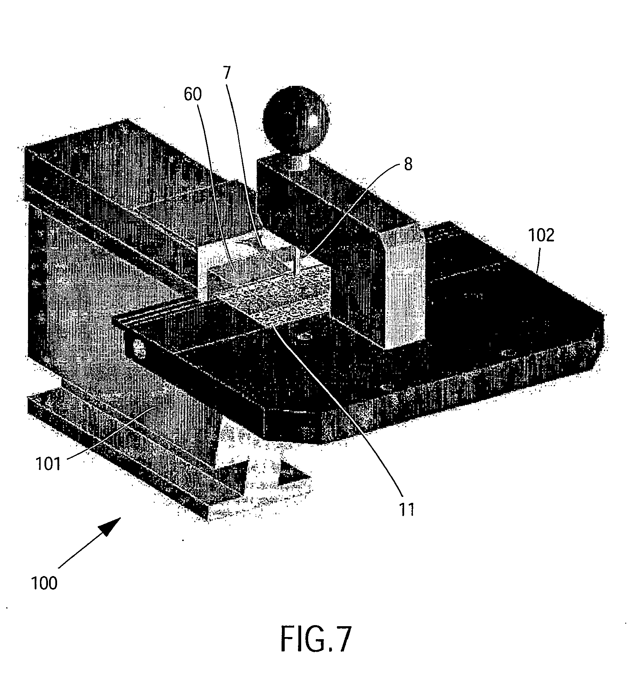

Figs. 7 through 9 are diagrammatic, perspective views of an apparatus for carrying out a method in accordance with the invention. The device 100 in accordance with the invention comprises (see Fig. 7) a base part 101 supporting a table 102 on which a lead frame 11 can be placed, preferably a frame comprising a large number of lead frames 11. As the table 102 is movable, for example by means of a worm wheel not shown in the drawing, also the lead frame 11 can be displaced. On one side of the frame 11, the device 100 comprises a pusher member 7, in this case in the form of a leaf spring. and a platform 60 which are attached to the base part 101. On the other side there is a pressure member 8 which is movably attached to the table 102.

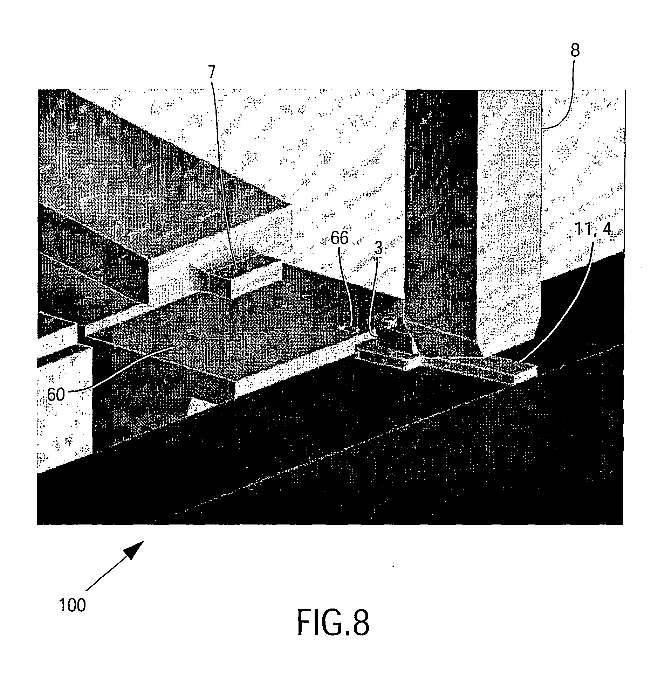

A part of the device 100 is shown in Fig. 8, wherein only a first conductor 4 of the lead frame 11 is depicted. This drawing shows that the platform 60 is provided with an opening 66 on which the element 3 can be positioned by means of a rotatable arm with tweezers, not shown. The opening 66 is connected to a suction device by means of which the element 3 can be fixed following its placement. The Figure further shows that the substrate of the lead frame is provided with a recess in which the conductor track 4 can be pressed downward by means of the pressure member 8. The element 3 can thus readily be slid from the platform 60 onto the first conductor 4 by means of the pressure member 7.

All this is shown again in Fig. 9, wherein the lead frame 11 is shown in its entirety. At this stage, the further conductors 5A, 5B have already been bent towards the first conductor 4 using bending members, not shown. The transistor 3 is now slid to position 4A on the first conductor, the latter being maintained in a pressed-down position by the pressure member 8.

The invention is not limited to the example described, and within the scope of the invention many variations and modifications are possible to those skilled in the art. For example, devices having a different geometry and/or different dimensions can be manufactured. In the examples, the semiconductor frame in question always is in one piece, however, it is alternatively possible to use a semiconductor frame composed of a plurality of parts.

Although an element is attached to the conductors preferably by means of soldering, alternative methods are also possible. For example, a conductive connection may be obtained by using an electroconductive adhesive which is subsequently cured. If the element is interposed between the conductors (which are bent towards each other) by pushing and sliding, such a connection can only be used for the upper side of the element on which no sliding takes place. However, the element may alternatively be brought to its position prior to the bending process. In that case, such a glued joint may be applied to two sides of the element.

## Claims

1. A method of manufacturing a semiconductor device (10) comprising the steps of:
- providing a semiconductor element (3) having a first and a second electrical connection region (1, 2), which connection regions are situated on opposite sides of the semiconductor element;
- providing a lead frame having a frame (11A) with a first and a second connection conductor (4, 5), which connection conductors (4, 5) are each connected to the frame (11A) and provided with an end portion, the end portion (4A) of the first connection conductor (4) being enlarged and the end portion of the second conductor (6) being widened, in which frame (11A) the first connection conductor (4) is provided with a hole (6) at a distance from the end portion (4A) of the first connection conductor (4), wherein the end portion of the second connection conductor is deformed, from a position within the frame outside the extension of the first connection conductor to a position outside the plane of the frame and opposite the connection position for the second connection region of the semiconductor element (3), by bending along a bending axis (B1) which is at an oblique angle with respect to the longitudinal axis of the end portion,
- placing the semiconductor element on the hole (6) in the first connection conductor (4) of the leadframe (11A),
- fixing the semiconductor element by means of a suction device present below the hole (6),
- applying the semiconductor element (3) to the end portion of the first connection conductor (4) by pushing the semiconductor element (3) between the connection conductors (4, 5) from its position on the hole (6) by means of a pusher member,
- making an electroconductive connection between the first connection region (1) and the end portion by using a connection means, and
- making an electroconductive connection between the second connection region (2) and the end portion of the second connection conductor (5) by using a connection means.

2. A method as claimed in claim 1, wherein the semiconductor element is clamped between the connection conductors (4,5).

3. Apparatus (100) for carrying out the method as claimed in claim 1 comprising:
- a transport mechanism for a lead frame (11) with at least two connection conductors (4, 5),
- bending means for bending at least one of the connection conductors along a bending axis,
- positioning means (60, 66) for positioning a semiconductor element (3);
- pusher means for pushing the semiconductor element (3) in between the two connection conductors (4,5), of which one (5) is bent to a position of the other one (4), and
- a suction device to fix the semiconductor element (3) when placed at a distance from the final position of the semiconductor element, prior to pushing the semiconductor element (3) using the pusher means.

## Patentansprüche

1. Verfahren zum Herstellen einer Halbleitervorrichtung (10), welches die Schritte aufweist:
Bereitstellen eines Halbleiterelements (3), welches einen ersten und einen zweiten elektrischen Verbindungsbereich (1, 2) aufweist, welche Verbindungsbereiche auf gegenüberliegenden Seiten des Halbleiterelements angeordnet sind;
Bereitstellen eines Leitungsrahmens, welcher einen Rahmen (11A) mit einem ersten und einem zweiten Verbindungsleiter (4, 5) aufweist, welche Verbindungsleiter (4, 5) jeweils mit dem Rahmen (11A) verbunden und mit einem Endabschnitt versehen sind, wobei der Endabschnitt (4A) des ersten Verbindungsleiters (4) vergrößert ist und der Endabschnitt des zweiten Leiters (5) verbreitert ist, in welchem Rahmen (11A) der erste Verbindungsleiter (4) in einem Abstand von dem Endabschnitt (4A) des ersten Verbindungsleiters (4) mit einem Loch (6) versehen ist, wobei der Endabschnitt des zweiten Verbindungsleiters deformiert ist von einer Position innerhalb des Rahmens außerhalb der Ausdehnung des ersten Verbindungsleiters zu einer Position außerhalb der Ebene des Rahmens und gegenüber der Verbindungsposition für den zweiten Verbindungsbereich des Halbleiterelements (3) mittels Biegens entlang einer Biegeachse (B1), welche einen schrägen Winkel bezüglich der longitudinalen Achse des Endabschnitt aufweist,
Platzieren des Halbleiterelements auf dem Loch (6) in dem ersten Verbindungsleiter (4) des Leitungsrahmens (11A),
Fixieren des Halbleiterelements mittels einer Saugvorrichtung, welche unterhalb des Loches (6) vorhanden ist,
Anbringen des Halbleiterelements (3) an den Endabschnitt des ersten Verbindungsleiters (4) mittels Drückens des Halbleiterelements (3) zwischen die Verbindungsleiter (4, 5) von seiner Position auf dem Loch (6) mittels eines Drückelements,
Ausbilden einer elektrisch leitfähigen Verbindung zwischen dem ersten Verbindungsbereich (1) und dem Endabschnitt mittels Verwendens eines Verbindungsmittels, und
Ausbilden einer elektrisch leitfähigen Verbindung zwischen dem zweiten Verbindungsbereich (2) und dem Endabschnitt des zweiten Verbindungsleiters (5) mittels Verwendens eines Verbindungsmittels.

2. Verfahren gemäß Anspruch 1, wobei das Halbleiterelement zwischen die Verbindungsleiter (4, 5) geklemmt ist.

3. Vorrichtung (100) zum Ausführen des Verfahrens wie im Anspruch 1 beansprucht, welche aufweist:
ein Transportmechanismus für einen Leitungsrahmen (11) mit zumindest zwei Verbindungsleitern (4, 5),
Biegemittel zum Biegen zumindest eines der Verbindungsleiter entlang einer Biegeachse,
Positioniermittel (60, 66) zum Positionieren eines Halbleiterelements (3);
Drückmittel zum Drücken des Halbleiterelements (3) zwischen die zwei Verbindungsleiter (4, 5), von denen eines (5) zu der Position des anderen (4) gebogen ist und
eine Saugvorrichtung zum Fixieren des Halbleiterelements (3), wenn es in einem Abstand von der finalen Position des Halbleiterelements platziert ist, bevor das Halbleiterelement (3) mittels Verwendens des Drückmittels gedrückt wird.

## Revendications

1. Procédé de fabrication d'un dispositif à semi-conducteurs (10) comprenant les étapes suivantes :
- mise en place d'un élément de semi-conducteurs (3) ayant une première et une deuxième région de connexion électrique (1, 2), lesquelles régions de connexion sont situées sur des faces opposées de l'élément de semi-conducteurs ;
- mise en place d'une grille de connexion ayant une structure (11A) avec un premier et un deuxième conducteur de connexion (4, 5), lesquels conducteurs de connexion (4, 5) sont raccordés chacun à la structure (11A) et comprennent une partie d'extrémité, la partie d'extrémité (4A) du premier conducteur de connexion (4) étant agrandie et la partie d'extrémité du deuxième conducteur (6) étant élargie, dans laquelle structure (11A) le premier conducteur de connexion (4) est muni d'un trou (6) à une certaine distance à partir de la partie d'extrémité (4A) du premier conducteur de connexion (4), dans lequel la partie d'extrémité du deuxième conducteur de connexion est déformée, d'une position dans la structure à l'extérieur de l'extension du premier conducteur de connexion jusqu'à une position à l'extérieur du plan de la structure et opposée à la position de connexion pour la deuxième région de connexion de l'élément semi-conducteur (3), par torsion le long d'un axe de torsion (B1) qui forme un angle oblique par rapport à l'axe longitudinal de la partie d'extrémité,
- placement de l'élément semi-conducteur sur le trou (6) dans le premier conducteur de connexion (4) de la grille de connexions (11A),
- fixation de l'élément semi-conducteur à l'aide d'un dispositif de succion présent sous le trou (6),
- application de l'élément à semi-conducteurs (3) sur la partie d'extrémité du premier conducteur de connexion (4) en poussant l'élément à semi-conducteur (3) entre les conducteurs de connexion (4, 5) à partir de sa position sur le trou (6) au moyen d'un élément poussoir,
- réalisation d'un raccordement conducteur de l'électricité entre la première région de connexion (1) et la partie d'extrémité à l'aide de moyens de connexion, et
- réalisation d'un raccordement conducteur de l'électricité entre la deuxième région de connexion (2) et la partie d'extrémité du deuxième conducteur de connexion (5) à l'aide de moyens de connexion.

2. Procédé selon la revendication 1, dans lequel l'élément semi-conducteur est serré entre les conducteurs de connexion (4, 5).

3. Appareil (100) pour réaliser le procédé selon la revendication 1, comprenant :
- un mécanisme de transport pour une structure de broche (11) avec au moins deux conducteurs de connexion (4, 5),
- des moyens de torsion pour tordre au moins l'un des conducteurs de connexion le long d'un axe de torsion,
- des moyens de positionnement (60, 66) pour positionner un élément semi-conducteur (3) ;
- des moyens de poussoir pour pousser l'élément semi-conducteur (3) entre les deux conducteurs de connexion (4, 5), dont l'un (5) est tordu vers une position de l'autre (4), et
- un dispositif de succion pour fixer l'élément semi-conducteur (3) lorsqu'il est placé à une certaine distance de la position finale de l'élément semi-conducteur, avant que l'élément à semi-conducteurs (3) ne soit poussé à l'aide des moyens de poussoir.
